Europäisches Patentamt

**European Patent Office**

Office européen des brevets

(11) Numéro de publication: **0 222 651**
**A1**

---

(12) **DEMANDE DE BREVET EUROPEEN**

---

(21) Numéro de dépôt: **86402323.9**

(22) Date de dépôt: **16.10.86**

(51) Int. Cl.⁴: **H 01 L 23/26**

---

(30) Priorité: **22.10.85 FR 8515661**

(43) Date de publication de la demande:
**20.05.87 Bulletin 87/21**

(84) Etats contractants désignés: **DE GB IT NL SE**

(71) Demandeur: **COMPAGNIE D'INFORMATIQUE MILITAIRE SPATIALE ET AERONAUTIQUE**
**25, rue de Courcelles**
**F-75008 Paris (FR)**

(72) Inventeur: **Val, Christian**
**THOMSON-CSF SCPI 19, avenue de Messine**
**F-75008 Paris (FR)**

(74) Mandataire: **Benoit, Monique et al**
**THOMSON-CSF SCPI 19, avenue de Messine**
**F-75008 Paris (FR)**

---

(54) **Dispositif de limitation de l'humidité dans une enceinte, notamment applicable à un boîtier de composant électronique.**

(57) L'invention a pour objet un dispositif de limitation de l'humidité dans une enceinte fermée, dispositif plus particulièrement applicable aux boîtiers de composants électroniques.

Le dispositif comporte :
- un matériau (3) d'une part susceptible de réagir chimiquement avec l'oxygène de l'eau contenue dans l'atmosphère ambiante pour former un oxyde à sa surface (30) et d'autre part susceptible de fixer l'hydrogène des molécules d'eau ainsi décomposées ;
- des moyens résistifs (2) permettant sur commande de chauffer la couche d'oxyde afin de permettre à la réaction chimique de formation d'oxyde de se poursuivre.

Le dispositif est fixé sur la paroi (7) intérieure par exemple d'un boîtier de composant électronique par une couche adhésive (8) et connecté électriquement par fils (51).

FIG_6

Bundesdruckerei Berlin

EP 0 222 651 A1

## Description

DISPOSITIF DE LIMITATION DE L'HUMIDITE DANS UNE ENCEINTE, NOTAMMENT APPLICABLE A UN BOITIER DE COMPOSANT ELECTRONIQUE

La présente invention a pour objet un dispositif de limitation de la teneur en humidité de l'atmosphère d'une enceinte fermée ; ce dispositif est notamment applicable aux boîtiers d'encapsulation de composants ou de circuits électroniques.

Ainsi qu'il est connu, le problème de la suppression ou, à défaut, de la limitation de l'humidité dans les boîtiers de composants électroniques est un problème aigü.

On sait en effet que le contaminant ayant le rôle le plus important et le plus néfaste sur le plan de la fiabilité d'un composant discret, d'un circuit intégré sur une pastille de semi-conducteur ou d'un circuit hybride, est la teneur en eau de l'ambiance environnante. En effet, notamment, l'humidité est susceptible de corroder les plots de connexions des circuits ; elle permet également aux ions de se solubiliser, ce qui renforce la corrosion. Cet effet est très sensible sur les circuits intégrés et il l'est d'autant plus que l'échelle d'intégration est plus élevée, c'est-à-dire que les plots de connexion sont plus petits.

Il existe plusieurs causes à la présence de molécules d'eau dans un boîtier renfermant un composant ou un circuit électronique.

Tout d'abord, il existe des causes externes. En effet, même lorsque l'on prend toutes les précautions connues pour éliminer les molécules d'eau de l'atmosphère avant la fermeture du boîtier, il en subsiste après fermeture. En outre, aussi soigneusement qu'ait été réalisé le scellement du capot du boîtier sur son embase, ce scellement présente toujours des fuites ; lors des variations des températures auxquelles sont généralement soumis les boîtiers, il se produit alors un effet de pompage à travers les fuites : à froid, la dépression intérieure conduit à admettre dans le boîtier de l'air extérieur, à l'humidité ambiante ; les molécules d'eau ainsi admises sont au moins partiellement fixées par les éléments situés à l'intérieur du boîtier ; lors d'une élévation de température, le gaz rendu à l'extérieur contiendra donc moins de molécules d'eau que celui qui avait été initialement admis et, de la sorte, le nombre de molécules d'eau tant à croître à l'intérieur du boîtier.

Il existe également des sources internes à l'accroissement de l'humidité dans le boîtier, qui sont principalement de deux sortes :
- d'une part, les molécules d'eau absorbées et adsorbées par le circuit et les éléments constitutifs du boîtier vont être libérées au cours de la vie du composant ; pour pallier cet inconvénient, on procède habituellement à un dégazage avant mise sous boîtier, mais celui-ci s'avère insuffisant notamment dans le cas des boîtiers de circuits intégrés à hautes performances ;
- d'autre part, il se produit une génération de molécules d'eau à l'intérieur du boîtier pendant la vie de celui-ci, due notamment à la recombinaison chimique des groupements OH et des protons, à des réactions de dévitrification dans les boîtiers contenant des verres, etc..

Différentes solutions sont connues pour résoudre ce problème d'humidité. Parmi celles-ci on peut citer :

- le fait d'incorporer dans le boîtier un circuit électronique assurant la détection de l'humidité et fournissant une alarme lorsque celle-ci dépasse une limite prédéfinie ; toutefois, lorsque le seuil d'alarme est atteint, le composant est considéré comme hors d'usage et remplacé : la solution est donc onéreuse ;

- le fait d'incorporer dans le boîtier un matériau susceptible de fixer les molécules d'eau ; cette solution présente une efficacité liée au pouvoir d'absorption du matériau ; or, ainsi qu'il est dit ci-dessus, les molécules d'eau sont admises ou créées dans le boîtier tout au long de la vie du composant ; après un certain temps de fonctionnement, le matériau absorbant n'est plus en mesure de fixer les nouvelles molécules d'eau et les inconvénients bien connus réapparaissent alors ;

- le fait d'incorporer dans le boîtier un dispositif susceptible de fixer les molécules d'eau associé à des moyens de chauffage assurant la régénération de ce matériau, afin de lui permettre de fixer les molécules d'eau au fur et à mesure de leur entrée ou de leur création dans le boîtier, tout au long de la vie du composant.

Toutefois, les observations de la déposante ont montré que cette dernière solution s'avèrait encore insuffisante dans certaines applications. Des études faites par la déposante ont mis en évidence le fait que la décomposition de la molécule d'eau par fixation de l'oxygène libère de l'hydrogène, dont la pression à l'intérieur du boîtier augmente de ce fait ; cela a pour effet de ralentir la réaction de fixation de l'oxygène, jusqu'à son arrêt complet lorsque la pression de l'hydrogène devient trop élevée. L'accroissement de l'humidité dans le boîtier, selon les mécanismes décrits plus haut, n'est plus alors limitée.

La présente invention a pour objet un dispositif permettant d'éviter ces divers inconvénients et limitations par le fait qu'il comporte :
- des moyens d'une part réagissant chimiquement avec l'oxygène de l'eau pour former un oxyde et, d'autre part, fixant l'hydrogène ;
- des moyens permettant, sur commande, de chauffer la couche d'oxyde, autorisant ainsi la réaction chimique de formation d'oxyde à se poursuivre.

D'autres objets, particularités et résultats de l'invention ressortiront de la description qui suit, illustrée par les dessins annexés qui représentent :
    - la figure 1, une vue en coupe d'un premier mode de réalisation du dispositif selon l'invention ;
    - la figure 2, une vue en coupe d'un deuxième mode de réalisation du dispositif selon l'invention, dans lequel celui-ci est muni de moyens d'isolation thermique ;

- la figure 3, une variante de la figure précédente ;

- la figure 4, une variante de réalisation du dispositif selon l'invention ;

- la figure 5, une autre variante du dispositif selon l'invention ;

- la figure 6, un mode de réalisation de la fixation et de la connexion électrique du dispositif selon l'invention à une enceinte dans laquelle l'humidité doit être limitée, telle qu'une paroi de boîtier de composant électronique ;

- la figure 7, une variante de la figure précédente.

Sur ces différentes figures, d'une part les mêmes références se rapportent aux mêmes éléments et, d'autre part, l'échelle réelle n'a pas été respectée pour la clarté de l'exposé.

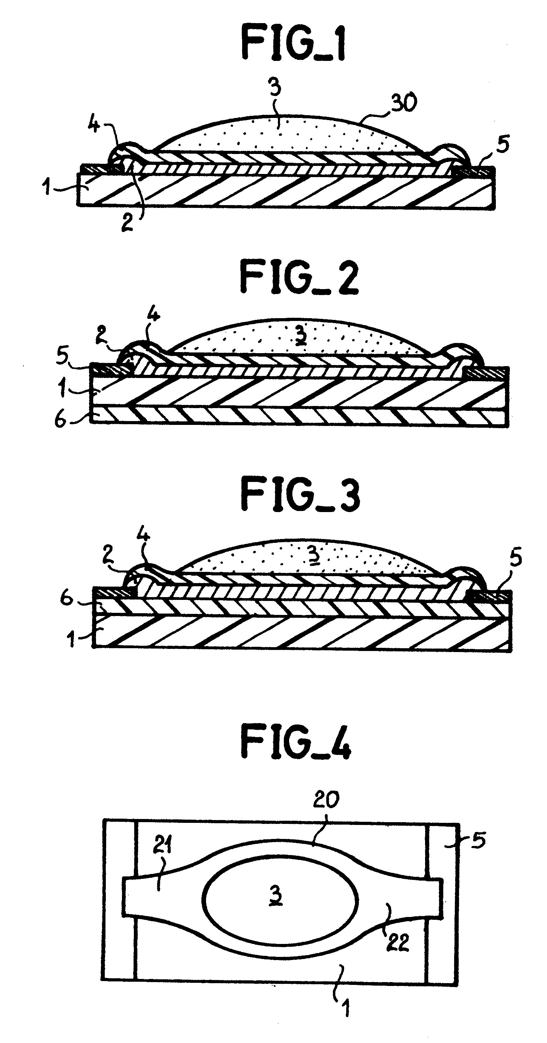

Sur la figure 1, on a représenté une plaquette 1 en matériau isolant, utilisée comme substrat pour le dispositif de l'invention. Sur l'une des faces de ce dernier, la face supérieure sur le dessin, on a disposé une couche 2 d'un matériau résistif destiné à chauffer des moyens 3. Dans le cas où les moyens 3 sont conducteurs de l'électricité, ils sont disposés sur la couche résistive 2 par l'intermédiaire d'une couche d'isolation électrique, comme représenté sur la figure (couche 4). Le dispositif comporte encore deux plots de connexion repérés 5, disposés par exemple respectivement aux deux extrémités de la couche résistive 2, sur le substrat 1, pour permettre la connexion électrique de la résistance 2 à une source de tension extérieure.

A titre d'exemple, le substrat 1 peut être en alumine, la résistance 2 par exemple déposée par sérigraphie et constituée d'un matériau à base d'oxyde de ruthénium, et la couche isolante 4 en verre, déposée également par exemple par sérigraphie.

Les moyens 3 ont donc pour fonction de réagir chimiquement avec l'oxygène, en formant un oxyde, afin de décomposer les molécules d'eau contenues dans l'atmosphère en contact avec sa surface (30), et d'assurer la fixation de l'hydrogène libéré par la décomposition précédente, afin d'éviter que la pression partielle de l'hydrogène n'augmente jusqu'à empêcher la réaction d'oxydation, comme mentionné plus haut, ou même réduire l'oxyde déjà formé. Le mécanisme de fixation de l'hydrogène peut être par exemple la formation de ce qui est connu sous le nom de "solution solide", c'està-dire l'insertion des atomes d'hydrogène dans la maille du matériau qui le piège. Ces moyens 3 sont constitués par exemple, comme représenté sur la figure 1, par une couche d'un matériau assurant les deux fonctions mentionnées ci-dessus et déposée sur la couche 2 ou sur la couche 4 ; ils peuvent être également constitués par deux matériaux distincts, mélangés ou déposés côte à côte sur la couche 4 (ou la couche 2), assurant respectivement les deux fonctions ci-dessus. Pour simplifier la description, on se place ci-après dans le cas où une même couche de matériau 3 assure ces deux fonctions.

En outre, l'oxyde formé par l'oxygène et le matériau 3 ne doit pas former une couche étanche et protectrice à la surface du matériau 3, couche qui empêcherait la formation ultérieure d'oxyde et par suite la fixation de l'oxygène de l'eau. Selon l'invention, la résistance 2 permet de chauffer le matériau 3 afin de favoriser la migration des atomes d'oxygène vers le matériau non encore oxydé et, le cas échéant, réciproquement la migration des atomes du matériau 3 vers la surface 30 afin de capter l'oxygène . De préférence, le matériau 3 est choisi de telle sorte que la température à laquelle il faut le porter pour assurer cette migration ne soit pas trop élevée afin, à la fois, de limiter la consommation d'énergie et l'élévation de température de l'environnement. En effet, dans le cas où le dispositif selon l'invention est placé dans un boîtier pour composant électronique, on sait que la dissipation de la chaleur dégagée par le composant lui-même constitue déjà une difficulté et qu'il est souhaitable de ne pas ajouter à cette chaleur celle du dispositif de piégeage de l'humidité.

Par ailleurs, les boîtiers de composant ne sont en général pas fermé sous vide, mais remplis de gaz. Dans ce cas, le matériau 3 peut être choisi de façon à être neutre vis-à-vis du gaz de remplissage du boîtier, l'azote en général, ou au moins contenir un composant qui le soit, tout en s'oxydant et/ou fixant l'hydrogène.

Le matériau 3 peut être par exemple du zirconium ou encore du titane, du magnésium, du béryllium ou du thorium. Il peut, dans une variante de réalisation, être constitué par un alliage réalisé à base d'un ou plusieurs des métaux précédents.

Dans une autre variante de réalisation, il peut lui être adjoint des quantités plus faibles de corps ayant pour fonction notamment de diminuer l'effet de protection de la couche d'oxyde qui se forme, par exemple quelques pour cents en poids. De tels additifs peuvent être par exemple de l'étain, du niobium ou de l'aluminium, ou encore zinc, fer, cuivre ou plomb.

Dans une autre variante, comme mentionné plus haut, il peut lui être adjoint un deuxième type d'additif assurant la fixation de l'hydrogène, tel que le titane.

Le matériau 3 peut être par exemple fixé sur la couche 4 (ou 2) par collage, refusion ou être déposé sur cette couche.

La figure 2 représente un deuxième mode de réalisation du dispositif selon l'invention, dans lequel celui-ci comporte de plus des moyens d'isolation thermique entre lui-même et le système récepteur dans lequel il est susceptible d'être monté.

Sur la figure 2, on a représenté à titre d'exemple un dispositif identique à celui de la figure 1 mais qui comporte en plus une couche 6 thermiquement isolante, disposée sur l'autre face du substrat 1, c'est à dire celle qui ne porte pas la couche résistive 2. Le dispositif est alors fixé sur le système récepteur du côté de la couche 6.

Cette couche d'isolation thermique 6 a pour but, en limitant l'échange de chaleur entre le dispositif et son système récepteur, d'une part de diminuer la consommation d'énergie nécessaire au chauffage du matériau 3 et, d'autre part, d'éviter l'élévation de température du système récepteur.

A titre d'exemple, cette couche d'isolation thermique 6 peut être en verre. Dans le cas où le substrat 1 est en alumine, le choix du verre présente un intérêt pratique : en effet, les substrats d'alumine sont fréquemment commercialement disponibles déjà recouverts d'une couche de verre.

La figure 3 représente une variante de réalisation de la figure précédente, dans laquelle la couche d'isolation thermique 6 est placée entre le substrat 1 et la couche résistive 2, les plots de connexion 5 étant comme précédemment placés en contact mécanique et électrique avec la couche 2, maintenant disposée sur la couche d'isolation 6.

Le dispositif est alors fixé sur le système récepteur par la face du substrat 1 qui ne porte pas la couche 6.

La figure 4 représente une variante de réalisation dans laquelle, toujours à des fins de limitation de la consommation d'énergie, la couche résistive présente une forme particulière.

Sur cette figure 4, le dispositif selon l'invention est vu de dessus et on distingue le substrat 1 sur lequel on a représenté la couche résistive, repérée 20, qui vient recouvrir en partie les plots de connexion 5. La couche résistive est elle-même recouverte du matériau 3, le cas échéant par l'intermédiaire de la couche d'isolation électrique 4, non représentée ici. Dans ce mode de réalisation, le matériau 3 se présente sous une forme sensiblement de goutte au centre du substrat 1 et la couche résistive 20 épouse sensiblement la forme du matériau 3, avec toutefois une superficie un peu plus étendue, et se prolonge en deux languettes repérées 21 et 22 entrant en contact avec les plots de connexion 5.

Ce mode de réalisation présente l'avantage de rendre la puissance dissipée maximale au niveau du matériau 3, c'est-à-dire là où elle est nécessaire, et corrélativement de la limiter ailleurs, ce qui constitue un avantage comme déjà mentionné plus haut.

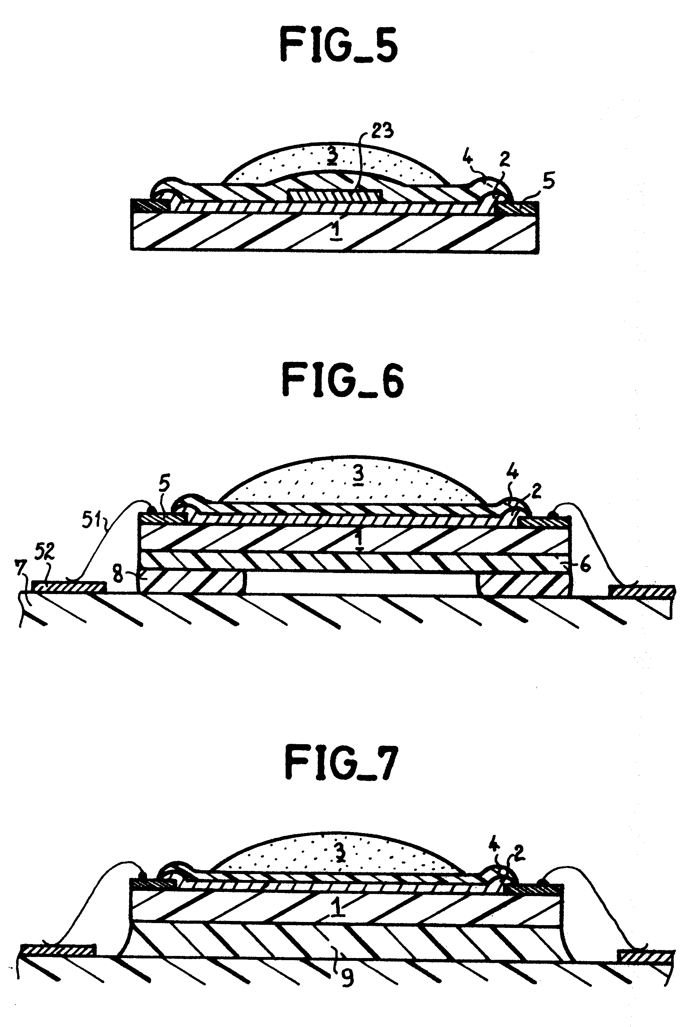

La figure 5 représente, vue en coupe, une autre variante de réalisation du dispositif selon l'invention dans lequel on a disposé une résistance supplémentaire.

Sur la figure 5, on a repris à titre d'exemple le mode de réalisation de la figure 1 et on a interposé au droit du matériau 3, entre la couche résistive 2 et la couche électriquement isolante 4, une résistance supplémentaire repérée 23, qui a également pour fonction d'accroître la puissance dissipée en chaleur au niveau du matériau 3.

La figure 6 représente un mode de réalisation de la fixation mécanique et électrique du dispositif selon l'invention à une paroi d'un système récepteur tel qu'une enceinte fermée, par exemple une paroi intérieure d'un boîtier de composant électronique, ou qu'un substrat de circuit hybride.

Sur cette figure, à titre d'exemple, on a repris pour le dispositif selon l'invention le mode de réalisation de la figure 2. Le dispositif est fixé mécaniquement à une paroi 7 par une couche 8 de fixation, de colle ou de verre par exemple, électriquement isolante. Les connexions électriques sont assurées à l'aide d'un fil de connexion 51 à des pistes conductrices ou des plots de connexion 52 de la paroi 7. La connexion par fils est préférée à une connexion par plots pour des raisons thermiques : la liaison des plots de connexions du dispositif aux plots 52 par soudure directe constituerait un pont thermique entre le dispositif et la paroi 7, ce qui est à éviter pour les raisons mentionnées plus hauts.

La couche de fixation 8 peut s'étendre sur toute la partie inférieure du dispositif (couche 6 dans cet exemple) ou sur seulement une portion de cette partie, comme représenté dans l'exemple de la figure 6.

La figure 7 représente une variante de réalisation de la figure précédente, dans laquelle on utilise pour réaliser la fixation mécanique du dispositif selon l'invention à la paroi 7, un matériau assurant en même temps l'isolation thermique.

Le dispositif selon l'invention est représenté comme illustré figure 1, à titre d'exemple. Il est fixé à la paroi 7 au moyen d'une couche 9 s'étendant sur la face du substrat qui ne porte pas la résistance 2, la couche 9 étant en outre thermiquement isolante ; elle peut être constituée par du verre ou une colle conductrice de la chaleur. La couche 9 peut être, comme la couche 8 de la figure 6, continue ou non. Les connexions électriques sont faites de préférence comme montré figure 6.

On a ainsi décrit ci-dessus un dispositif de limitation de l'humidité, se présentant sous la forme d'une microplaquette, susceptible d'être placée et connectée aisément à l'intérieur d'un boîtier de composant de circuit électronique ; ce dispositif permet de fixer les molécules d'eau, par décomposition, et son pouvoir fixateur est renouvelable sur commande extérieure (mise sous tension du matériau résistif 2).

La description faite ci-dessus l'a été à titre d'exemple non limitatif et d'autres variantes sont bien entendu possibles, qui rentrent dans le cadre de l'invention. C'est ainsi par exemple que d'autres formes sont possibles pour les plots de connexion 5 du matériau résistif 2, aussi bien vus de dessus que vus en coupe, sous réserve de ne pas former de pont thermique entre le substrat 7 et le dispositif selon l'invention.

**Revendications**

1. Dispositif de limitation de l'humidité dans une enceinte, caractérisé par le fait qu'il comporte :
- des premiers moyens (3) d'une part réagissant chimiquement avec l'oxygène pour former au moins un oxyde, détruisant ainsi les molécules d'eau, et d'autre part fixant l'hydrogène ;
- des deuxièmes moyens (2) assurant, sur commande, le chauffage de l'oxyde, et par suite la poursuite de la réaction chimique de formation d'oxyde.

2. Dispositif selon la revendication 1, caractérisé par le fait que les premiers moyens sont constitués d'une couche d'un matériau (3) qui comporte au moins l'un des corps suivants : zirconium, titane, bérillium, thorium.

3. Dispositif selon l'une des revendications précédentes, caractérisé par le fait que les premiers moyens (3) comportent au moins un matériau additif assurant la diminution de l'effet de protection desdits moyens par l'oxyde.

4. Dispositif selon la revendication 3, caractérisé par le fait que le matériau additif comporte au moins l'un des corps suivants : étain, niobium, aluminium.

5. Dispositif selon l'une des revendications précédentes, caractérisé par le fait que les moyens de chauffage (2) sont constituée par une couche résistive disposée au voisinage desdits premiers moyens (3), susceptible de chauffer ce dernier lorsqu'elle est parcourue par un courant électrique.

6. Dispositif selon la revendication 5, caractérisé par le fait que la couche résistive (2) épouse sensiblement la forme desdits premiers moyens (3) et est en contact thermique avec ceux-ci, de sorte à avoir un maximum de dissipation thermique au niveau desdits moyens (3).

7. Dispositif selon l'une des revendications 5 ou 6, caractérisé par le fait qu'il comporte une deuxième couche résistive (23) disposée de sorte à augmenter la dissipation thermique au niveau desdits premiers moyens (3).

8. Dispositif selon l'une des revendications 5 à 7, caractérisé par le fait qu'il comporte en outre un substrat (1) sur lequel sont déposés la couche résistive (2) et deux plots (5) de connexion de cette dernière.

9. Dispositif selon la revendication 8, caractérisé par le fait qu'il comporte en outre une couche (4) électriquement isolante entre la couche résistive (2) et lesdits premiers moyens (3).

10. Dispositif selon l'une des revendications précédentes, qu'il comporte en outre des moyens d'isolation thermique (6, 9).

11. Boîtier de composant ou circuit électronique, caractérisé par le fait qu'il comporte un dispositif selon l'une des revendications précédentes, fixé à l'aide de moyens de fixation (8).

12. Boîtier selon les revendications 8 et 11, caractérisé par le fait que les moyens de fixation comportent une couche (9) disposée sur la face du substrat (1) qui ne porte pas la couche résistive (2), assurant à la fois l'isolation thermique du dispositif par rapport au boîtier et la fixation du dispositif sur une paroi intérieure du boîtier.

0222651

FIG_1

FIG_2

FIG_3

FIG_4

0222651

# FIG_5

# FIG_6

# FIG_7

## Office européen des brevets

# RAPPORT DE RECHERCHE EUROPEENNE

Numero de la demande

EP  86 40 2323

## DOCUMENTS CONSIDERES COMME PERTINENTS

| Catégorie | Citation du document avec indication, en cas de besoin. des parties pertinentes | Revendication concernée | CLASSEMENT DE LA DEMANDE (Int Cl 4) |
|---|---|---|---|
| Y | EP-A-0 113 282  (COMPAGNIE D'INFORMATIQUE MILITAIRE SPATIALE ET AERONAUTIQUE) * En entier * | 1,2 | H 01 L  23/26 |
| A | | 5-9 | |
| | --- | | |
| Y | US-A-3 007 089  (A.J. KING) * Colonne 1, lignes 35-49 * | 1,2 | |
| | --- | | |
| A | FR-A-2 462 841  (SIEMENS) * Page 2, lignes 1-5 * | 1 | |
| | --- | | |
| A | US-A-2 820 931  (F. KOURY) * Colonne 3, lignes 13-23 * | 1,2 | |
| | ----- | | |

DOMAINES TECHNIQUES RECHERCHES (Int Cl 4)

H 01 L
H 05 K

Le présent rapport de recherche a été établi pour toutes les revendications

| Lieu de la recherche | Date d'achèvement de la recherche | Examinateur |
|---|---|---|
| LA HAYE | 23-01-1987 | TOUSSAINT F.M.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons

& : membre de la même famille, document correspondant

OEB Form 1503 03 82